# EUROPÄISCHE PATENTANMELDUNG

(11) **EP 2 104 231 A1**
(43) Veröffentlichungstag der Anmeldung: **23.09.2009**
(21) Anmeldenummer: 08005044.6
(22) Anmeldetag: 18.03.2008
(51) Int. Cl.: H03K 3/012, H03K 19/003

(54) **Schaltung zur Generierung einer Rechteckimpulsfolge**

(71) Anmelder: SIEMENS AKTIENGESELLSCHAFT, 80333 München (DE)
(72) Erfinder: Hauselt, Peter, 92284 Poppenricht (DE)

(57) **Zusammenfassung**

Es wird eine Schaltung zur Generierung einer Rechteckimpulsfolge als Sendesignal angegeben, wobei die Schaltung einen Impulsgenerator (18) und einen Entladeimpulsgenerator (20) umfasst und sich dadurch auszeichnet, dass der Entladeimpulsgenerator (20) einen Entladeimpuls direkt aus dem Sendesignal generiert.

## Beschreibung

Die Erfindung betrifft eine Schaltung zur Generierung einer Rechteckimpulsfolge als Sendesignal, z. B. zur Generierung eines seriellen digitalen Datenstroms, wie er z. B. durch an sich bekannte, so genannte Kommunikationsbausteine (Controller), namentlich so genannte UARTs, insbesondere die bekannten Typen 8250 und 16550 der Firma National Semiconductor, erzeugt werden. Mit einer derartigen Rechteckimpulsfolge wird zu benachbarten Geräten eine Kommunikation aufgebaut. Um die Kommunikation herzustellen, werden die Sendesignale auf einer Datenleitung übertragen, die mit einer kapazitiven Last beaufschlagt werden kann.

Als problematisch hat sich dabei erwiesen, dass auf der Datenleitung Rechtecksignale generiert werden müssen, die einen hohen Spannungshub und steile Flanken aufweisen. Die Pegel auf der Leitung sind für Low:0V-8V und für High: 13V-30V. Die Flankensteilheit beträgt für steigende und fallende Flanken 20% der Bitzeit, also z. B. t=800ns. In Kommunikationspausen muss die Schaltung inaktiv und hochohmig sein. Daher darf ein Entladeimpuls nicht dauerhaft anliegen oder es muss eine separate Sende-Empfangs-Umschaltung eingebaut werden. Außerdem sind die Schalt- und Ausräumzeiten der Transistoren zu berücksichtigen.

Beim Wechsel vom High- auf Low-Signal muss aufgrund der geforderten Flankensteilheit die Datenleitung in kurzer Zeit entladen werden. Auch dürfen sich eine Lade- und eine Entladephase der Datenleitung nicht überschneiden, weil es sonst zu unerwünschten Querströmen kommen kann. Das bedeutet, dass ein auf ein High-Signal folgendes Low-Signal einen verzögerten Entladeimpuls benötigt. Die Gesamtlänge des Entladeimpulses muss so bemessen sein, dass die Leitungskapazität vollständig entladen wird. Der Entladeimpuls darf außerdem nicht in eine mit dem nächsten High-Signal beginnende Ladephase hineinragen. Ein festgelegter Stromwert (I≤200mA) darf dabei auch nicht überschritten werden. Während der Empfangsphase muss die Schaltung hochohmig sein, um den Empfangsweg nicht zu beeinflussen.

Bisherige Lösungen zur Behandlung der oben skizzierten Problematik basieren auf der Verwendung eines Prozessors nach Art eines FPGA, CPLD, usw. zur Generierung des Entladeimpulses. Es ist dazu bei einer Verwendung der Schaltung zur Kommunikation zwischen Geräten, die in der Kommunikationsbeziehung als Master und als Slave fungieren, die Auswertung eines vom als Master fungierenden Gerät abgesetzten Umschaltsignals zur Sende-Empfangs-Umschaltung vorgesehen, um die Hochohmigkeit der Schaltung zu gewährleisten.

Das Erzeugen eines solchen Signals und dessen Auswertung auf Seiten der Gegenstelle ist in nachteiliger Art und Weise aufwendig und bei Controllern der eingangs genannten Art, mit denen üblicherweise eine Generierung einer Rechteckimpulsfolge der hier in Frage stehenden Art erfolgt, nicht integrierbar, da dazu ein zusätzlicher Ausgang des Mikrocontrollers erforderlich wäre.

Eine Aufgabe der vorliegenden Erfindung besteht entsprechend darin, eine Schaltung der eingangs genannten Art anzugeben, die die oben skizzierten Nachteile vermeidet und die bei Kommunikationsverbindungen nach einem neuen, derzeit unter der Bezeichnung "IO-Link" bekannten, durchgängigen Kommunikationsstandard für Sensoren und Aktoren verwendbar ist. Namhafte Hersteller von Sensor- und Automatisierungstechnik, u.a. die Anmelderin der vorliegenden Erfindung, haben sich zusammengefunden um diesen Kommunikationsstandard zu erarbeiten. Als dabei zu erfüllende technische Randbedingungen sind die o. g. Pegel (Low:0V-8V und High: 13V-30V), ein festgelegter maximaler Stromwert (I≤200mA), eine geforderte Flankensteilheit (20% der Bitzeit, insbesondere t=800ns) und eine maximale kapazitive Last (5nF) zu beachten.

Diese Aufgabe wird erfindungsgemäß mit einer Schaltung mit den Merkmalen des Anspruchs 1 gelöst. Dazu ist bei einer Schaltung zur Generierung einer Rechteckimpulsfolge, insbesondere einer Rechteckimpulsfolge mit und unter den o. g. Randbedingungen, als Sendesignal mit einem Impulsgenerator und einem Entladeimpulsgenerator vorgesehen, dass der Entladeimpulsgenerator einen Entladeimpuls aus dem Sendesignal, insbesondere direkt aus dem Sendesignal, generiert.

Der Vorteil der Erfindung besteht darin, dass durch die Generierung des Entladeimpulses aus dem Sendesignal, also aus der von der Schaltung generierten Rechteckimpulsfolge, die das Sendesignal darstellt, an einem als Impulsgenerator fungierenden Mikrocontroller kein zusätzlicher Ausgang, über den ansonsten der Entladeimpuls erzeugt werden könnte, benötigt wird.

Vorteilhafte Ausgestaltungen der Erfindung sind Gegenstand der Unteransprüche. Dabei verwendete Rückbeziehungen weisen auf die weitere Ausbildung des Gegenstandes des Hauptanspruches durch die Merkmale des jeweiligen Unteranspruches hin; sie sind nicht als ein Verzicht auf die Erzielung eines selbständigen, gegenständlichen Schutzes für die Merkmalskombinationen der rückbezogenen Unteransprüche zu verstehen. Des Weiteren ist im Hinblick auf eine Auslegung der Ansprüche bei einer näheren Konkretisierung eines Merkmals in einem nachgeordneten Anspruch davon auszugehen, dass eine derartige Beschränkung in den jeweils vorangehenden Ansprüchen nicht vorhanden ist.

Bevorzugt umfasst der zur Schaltung gehörende Entladeimpulsgenerator ein erstes und ein zweites ansteuerbares Schaltelement, wobei das erste Schaltelement im angesteuerten Zustand eine Datenleitung, über die im Betrieb das Sendesignal übertragen wird, mit einem ersten Bezugspotential verbindet und das zweite Schaltelement im angesteuerten Zustand die Datenleitung mit einem zweiten Bezugspotential, insbesondere Massepotential, verbindet. Die gesteuerte Verbindung der Datenleitung mit entweder dem ersten oder dem zweiten Bezugspotential bewirkt die erforderliche Flankensteilheit und insbesondere die schnelle Entladung der Datenleitung.

Eine besonders einfache schaltungstechnische Realisierung einer solchen gesteuerten Verbindbarkeit der Datenleitung mit entweder dem ersten oder dem zweiten Bezugspotential besteht darin, dass die Datenleitung mit einem Mittelanschluss einer Reihenschaltung von erstem und zweitem Schaltelement verbunden ist, wobei die Schaltelemente selbst mit ihrem dem zum Mittelanschluss zusammengefassten Kontakt gegenüberliegenden Kontakt mit dem jeweiligen Bezugspotential verbunden sind.

Zur Generierung des Entladeimpulses wirkt das Sendesignal direkt auf das erste Schaltelement und verzögert auf das zweite Schaltelement. Dadurch werden schädliche Querströme vermieden, die sich ergeben, wenn das erste Schaltelement noch leitend ist und zu diesem Zeitpunkt bereits das zweite Schaltelement angesteuert würde.

Zur verzögerten Wirkung auf das zweite Schaltelement ist bevorzugt ein Verzögerungsglied vorgesehen, dass auch als Zähler oder als Teiler realisiert sein kann.

Zur Begrenzung einer Dauer des Entladeimpulses im Signalpfad zum zweiten Schaltelement ist ein Impulsglied vorgesehen, das einen Impuls einer vorgegebenen oder vorgebbaren Länge erzeugt und somit für eine auch zeitlich definierte Ansteuerung des zweiten Schaltelementes sorgt.

Nachfolgend wird ein Ausführungsbeispiel der Erfindung anhand der Zeichnung näher erläutert. Einander entsprechende Gegenstände oder Elemente sind in allen Figuren mit den gleichen Bezugszeichen versehen.

Das oder jedes Ausführungsbeispiel ist nicht als Einschränkung der Erfindung zu verstehen. Vielmehr sind im Rahmen der vorliegenden Offenbarung zahlreiche Abänderungen und Modifikationen möglich, insbesondere solche Varianten, Elemente und Kombinationen, die zum Beispiel durch Kombination oder Abwandlung von einzelnen in Verbindung mit den im allgemeinen oder speziellen Beschreibungsteil beschriebenen sowie in den Ansprüchen und/oder der Zeichnung enthaltenen Merkmalen bzw. Elementen oder Verfahrensschritten für den Fachmann im Hinblick auf die Lösung der Aufgabe entnehmbar sind und durch kombinierbare Merkmale zu einem neuen Gegenstand oder zu neuen Verfahrensschritten bzw. Verfahrensschrittfolgen führen.

Es zeigen
- FIG 1: zwei über eine Datenleitung kommunizierende Geräte,
- FIG 2: eine Ausführungsform der erfindungsgemäßen Schaltung,
- FIG 3: ein schematisch vereinfachtes Diagramm von in der Schaltung erzeugten oder vorkommenden Signalen und
- FIG 4: zur Gegenüberstellung mit der erfindungsgemäßen Lösung eine Schaltung die auf dem Erhalt eines externen Umschaltsignals basiert.

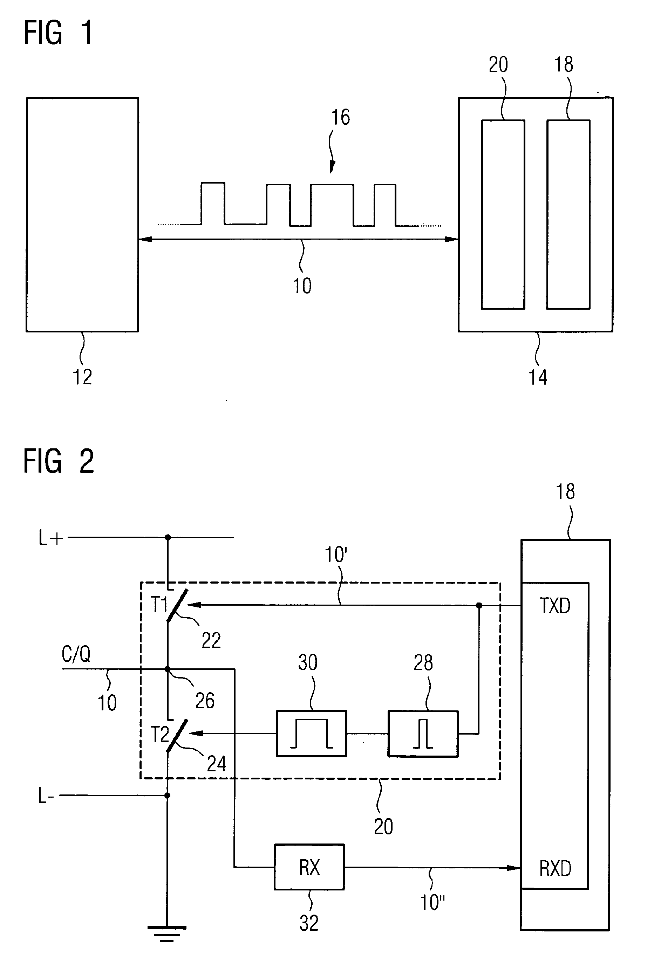

FIG 1 zeigt schematisch vereinfacht zwei über eine Datenleitung 10 kommunizierende Geräte. Die Geräte werden im Folgenden zur Unterscheidung als Master 12 und als Slave 14 bezeichnet. Als Master 12 kommt z. B. ein so genanntes dezentrales Peripheriegerät zur Steuerung und/oder Überwachung eines technischen Prozesses (nicht dargestellt) in Zusammenhang mit dessen Automatisierung in Betracht. Als Slave 14 kommen im technischen Prozess befindliche Sensoren, also z. B. (End-)Schalter, Messwertaufnehmer, usw., und Aktoren, also z. B. Ventile, Motoren und Aggregate, usw., in Betracht.

Über die Datenleitung 10 wird als Rechteckimpulsfolge 16 ein Sendesignal übertragen. Dazu umfasst zumindest eines der Geräte, im dargestellten Fall das als Slave 14 fungierende Gerät einen Impulsgenerator 18 und einen Entladeimpulsgenerator 20. Die Funktion als Master 12 oder als Slave 14 wird durch eine Konfiguration der Geräte festgelegt. Die Schaltung mit Impulsgenerator 18 und Entladeimpulsgenerator 20 kann entsprechend genauso in einem als Master 12 fungierenden Gerät vorhanden sein. In der Praxis wird man bei allen zur seriellen Kommunikation vorgesehenen Geräten eine solche Schaltung vorsehen um eine größtmögliche Flexibilität zu erreichen.

Als Impulsgenerator 18 kommt häufig ein als UART bezeichneter Mikrocontroller zum Einsatz, der zur seriellen Datenübertragung vorgesehen und damit zur Generierung einer Rechteckimpulsfolge 16 als Sendesignal geeignet ist. Dem Impulsgenerator 18 ist im Hinblick auf eine Generierung und Übermittlung der Rechteckimpulsfolge 16 ein Entladeimpulsgenerator 20 nachgeordnet. Für die serielle Kommunikation werden Sendesignale, also die Rechteckimpulsfolge 16 oder Abschnitte davon, auf der Datenleitung 10 übertragen, die mit einer kapazitiven Last (max. 5nF) beaufschlagt werden kann. Auf der Datenleitung 10 müssen Rechteckimpulse generiert werden, die einen hohen Spannungshub und steile Flanken aufweisen. Die Pegel auf der Leitung sind beispielsweise für Low: 0V-8V und für High: 13V-30V. Die Flankensteilheit beträgt für steigende und fallende Flanke 20% der Bitzeit, also z. B. t=800ns. Beim Wechsel von einem High-Signal zu einem Low-Signal muss also die Datenleitung 10 in einer kurzen Zeit entladen werden. Auch dürfen sich die Lade- und Entladephase der Datenleitung 10 nicht überschneiden, so dass ein auf ein High-Signal folgendes Low-Signal einen verzögerten Entladeimpuls benötigt. Die Gesamtlänge eines Entladeimpulses muss so bemessen sein, dass die Leitungskapazität vollständig entladen wird, ohne dass der Entladeimpuls in eine mit einem nachfolgenden High-Signal assoziierte Ladephase hineinragt. Ein festgelegter Stromwert (I≤200mA) darf ebenfalls nicht überschritten werden. Diese Randbedingungen werden mit dem Entladeimpulsgenerator 20 erfüllt. Zudem ist eine besondere Eigenschaft des Entladeimpulsgenerators 20, dass eine davon umfasste Schaltung in Kommunikationspausen inaktiv und hochohmig ist, der Entladeimpuls mithin nicht dauerhaft anliegt und dass der Entladeimpuls direkt aus dem Sendesignal, also der jeweiligen Rechteckimpulsfolge 16, generiert wird, ohne dass dafür etwa ein z. B. vom Master 12 zu erzeugendes Signal zur Sende-Empfangs-Umschaltung mit entsprechender Auswertung auf der Gegenseite nötig wäre.

Üblicherweise ist vorgesehen, dass ein als Slave 14 fungierendes Gerät keine eigene Sendeberechtigung hat und entsprechend die Datenleitung 10 nur nach einer vorherigen Anforderung durch den Master 12 belegt. Ein übliches Szenario sieht dabei so aus, dass der Master 12 Daten zum Slave 14 überträgt, z. B. eine Anforderung aktualisierte Messwerte zu liefern, und der Slave 14 daraufhin mit einer Bereitstellung und Übertragung der angeforderten Daten antwortet. In diesem Szenario ergibt sich auch die bisher notwendige Sende-Empfangs-Umschaltung. Bisher aktiviert das jeweilige Gerät mit einem Sendewunsch die Sende-Empfangs-Umschaltung. Nachdem nur das als Master 12 fungierende Gerät eine eigene Sendeberechtigung hat, kommt es dabei normalerweise nicht zu Kollisionen. Mit dem Empfang einer Sendeanforderung vom Master 12 kann der Slave 14 seinerseits die Sende-Empfangs-Umschaltung aktivieren um Daten über die Datenleitung 10 übertragen zu können. Mit dem Ende dieser Datenübertragung oder im Zusammenhang mit einem erneuten Sendewunsch kann der Master 12 die Sende-Empfangs-Umschaltung aktivieren um seinerseits wieder Daten über die Datenleitung übertragen zu können.

FIG 2 beschreibt den Entladeimpulsgenerator 20 mit weiteren Details. Ebenfalls gezeigt ist der Impulsgenerator 18, der hier als Mikrocontroller mit Ein-/Ausgängen TXD, RXD gezeigt ist. Der Entladeimpulsgenerator 20 generiert einen Entladeimpuls direkt aus dem über TXD ausgegebenen Sendesignal. Das Sendesignal wird über die von TXD ausgehende Sendeleitung 10' übertragen. Im Falle von Sendungen der Gegenstelle, also z. B. dem in FIG 1 gezeigten Master 12, erfolgt deren Empfang über den Eingang RXD und die dort endende Empfangsleitung 10". Im Einzelnen umfasst der Entladeimpulsgenerator 20 ein erstes und ein zweites ansteuerbares Schaltelement 22, 24, wobei das erste Schaltelement 22 im angesteuerten Zustand die Datenleitung 10 mit einem ersten Bezugspotential (hier als L+ dargestellt) verbindet. Das zweite Schaltelement 24 verbindet im angesteuerten Zustand die Datenleitung 10 mit einem zweiten Bezugspotential, insbesondere Massepotential (hier als L-dargestellt). Die schaltungstechnische Anordnung der beiden Schaltelemente 22, 24 ist derart, dass zur Verbindung der Datenleitung 10 entweder mit dem ersten oder zweiten Bezugspotential die Datenleitung 10 mit einem Mittelanschluss 26 einer Reihenschaltung von erstem und zweitem Schaltelement 22, 24 verbunden ist.

Zur Generierung des Entladeimpulses wirkt das Sendesignal, also das am Ausgang TXD generierte Signal, direkt auf das erste Schaltelement 22 und verzögert auf das zweite Schaltelement 24. Zur verzögerten Wirkung auf das zweite Schaltelement 24 ist ein Verzögerungsglied 28 vorgesehen. Zur Begrenzung einer Dauer des Entladeimpulses ist im Signalpfad zum zweiten Schaltelement 24 darüber hinaus ein Impulsglied 30 vorgesehen und zwar in Richtung auf das zweite Schaltelement 24 hinter dem Verzögerungsglied 28. Der Entladeimpuls wird also direkt aus dem Sendesignal generiert.

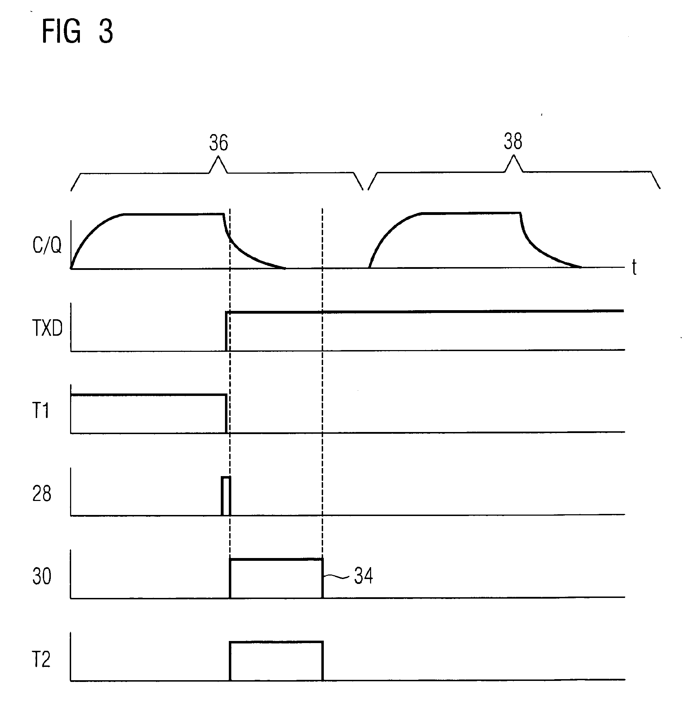

In Verbindung mit der Darstellung in FIG 3, die ein Zeitdiagramm einzelner Signale zeigt, wird nachfolgend die Wirkungsweise der in FIG 2 gezeigten Schaltung erläutert.

Um die Datenleitung 10 in kurzer Zeit entladen zu können, ist als gesteuerte Entladeschaltung der Entladeimpulsgenerator 20 vorgesehen. Der definierte Entladeimpuls wird aus dem vorhandenen Sendesignal, das über den Ausgang TXD des Impulsgenerators 18 abgegeben wird, abgeleitet und mit Hilfe von Zeitgliedern, also dem Verzögerungsglied 28 und dem Impulsglied 30, die auch als Zähler oder Teiler realisiert sein können. Dabei müssen die Ausräumzeiten der Schaltelemente 22, 24, die bevorzugt als elektronisch ansteuerbare Schaltelemente, also insbesondere Transistoren, ausgeführt sind, berücksichtigt werden. Im Einzelnen:

Das vom Impulsgenerator 18 über den Ausgang TXD gelieferte Sendesignal steuert bei Low-Pegel das erste Schaltelement 22 an und zieht dadurch die Datenleitung 10, die in FIG 3 als "C/Q" bezeichnet ist, auf High-Potential. Wechselt TXD auf High-Pegel, so wird das erste Schaltelement 22 geöffnet und das Verzögerungsglied 28 angesteuert, das seinerzeit nach Verstreichen einer durch dessen Implementation begründeten Verzögerungszeit das Impulsglied 30 startet. Hier wird der eigentliche Entladeimpuls mit definierter Länge erzeugt und so durch Ansteuerung des zweiten Schaltelements 24 die Entladung der Datenleitung 10 bewirkt. Da das erste Schaltelement 22 nach Abschaltung noch etwas nachläuft, bis eine interne Restladung abgebaut ist, reduziert das Verzögerungsglied 28 einen eventuellen, schädlichen Querstrom, der sich dann ergibt, wenn das erste Schaltelement 22 noch leitend ist und das zweite Schaltelement 24 bereits angesteuert würde. Nach der Entladung der Datenleitung 10 sind beide Schaltelemente 22, 24 in einem Ruhezustand, also geöffnet und hochohmig, und beeinflussen so den Empfangszweig mit dem Empfänger 32 der Empfangsleitung 10" im Falle einer Einprägung eines Sendesignals durch die Gegenseite und dessen nachfolgenden Empfang über RX und RXD nicht.

In FIG 3 ist dazu von oben nach unten zunächst das über die Datenleitung 10 (FIG 2) übertragene Signal dargestellt. Die dargestellte Abweichung von der idealen Rechteckimpulsfolge 16 ergibt sich in an sich bekannter Art und Weise durch technisch bedingte Lade- und Entladevorgänge. Darunter ist ein Beispiel für ein am Ausgang TXD des Impulsgenerators 18 (FIG 1) abgebbares Signal dargestellt. Nochmals darunter ist ein Zustand des ersten Schaltelements 22 (FIG 1) - in beiden Darstellungen auch mit T1 bezeichnet - dargestellt, der sich unmittelbar aus dem Sendesignal, also dem an TXD ausgegebenen Signal, ergibt. Dargestellt ist auch, dass der Flankenwechsel des TXD-Signals nicht unmittelbar mit einer entsprechenden Zustandsänderung des ersten Schaltelements 22 zusammenfällt, weil dieses aufgrund physikalischer Effekte während einer Nachlaufzeit eine Restladung abbaut, insbesondere wenn das erste Schaltelement 22 als elektronisch ansteuerbares Schaltelement, also als Transistor und dergleichen, realisiert ist.

Zur Kompensation von mit einem Abbau einer Restladung eventuell zu besorgenden Querströmen ist das Verzögerungsglied 28 vorgesehen und ein von diesem generiertes Signal ist in FIG 3 in dem mit 28 bezeichneten Diagramm dargestellt. Das Verzögerungsglied 28 steuert seinerseits das Impulsglied 30 (FIG 2) an und das Impulsglied 30 erzeugt den eigentlichen Entladeimpuls 34, der in FIG 3 in dem mit 30 bezeichneten Diagramm dargestellt ist. Das Impulsglied 30 erzeugt einen Entladeimpuls 34 mit einer durch die Implementation des Impulsgliedes 30 vorgegebenen Länge, wobei die Länge so gewählt ist, dass die Datenleitung 10 sicher entladen ist. Mit dem Entladeimpuls 34 wird das zweite Schaltelement 24 angesteuert, so dass die Darstellung in FIG 3 mit dem Verlauf des Zustands des zweiten Schaltelements 24 - in beiden Darstellungen auch als T2 bezeichnet - schließt. Mit der Entladung der Datenleitung 10 (FIG 2) ist der Entladeimpulsgenerator 20 (FIG 2) hochohmig, so dass sich an eine damit eventuell abgeschlossene Sendephase 36 eine Empfangsphase 38 anschließen kann.

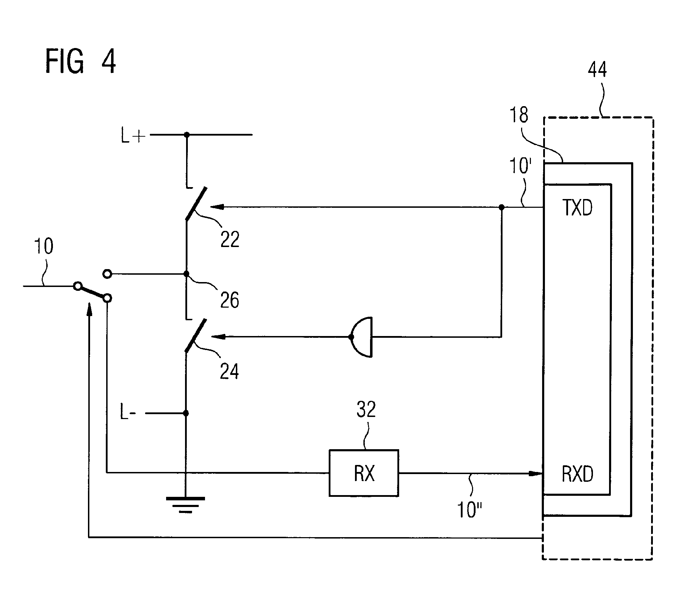

Abschließend wird nun anhand von FIG 4 gezeigt, dass der wesentliche Vorteil der erfindungsgemäßen Schaltung gemäß FIG 2 vor allem darin liegt, dass keine Sende-Empfangs-Umschaltung notwendig ist und dass für eine solche Sende-Empfangs-Umschaltung, die mit der Erfindung genau vermieden wird, beim Impulsgenerator 18 ein zusätzlicher Prozessorausgang erforderlich wäre, was, nachdem als Impulsgenerator 18 normalerweise handelsübliche Mikrocontroller verwendet werden oder solche Impulsgeneratoren 18 Bestandteil handelsüblicher Mikrocontroller sind, bei denen Art und Anzahl der Ein- und Ausgänge festliegen, nicht möglich ist. Nachfolgend aber dennoch zumindest kursorisch eine Beschreibung der in FIG 4 dargestellten Schaltung, die soweit wie möglich parallel zu der in FIG 2 dargestellten Schaltung gezeichnet ist und gleiche Bezugszeichen verwendet:

Zur Einprägung des über TXD ausgegebenen Sendesignals auf die Datenleitung 10 mit einer ausreichenden Leistung werden wie bei der Schaltung in FIG 2 die beiden Schaltelemente 22, 24 verwendet, die über den Ausgang TXD angesteuert werden und die Datenleitung 10 je nach Pegel des an TXD abgegebenen Signals entweder mit dem ersten Bezugspotential L+ oder dem zweiten Bezugspotential L- verbunden. Ohne eine Auflösung der in Ansehung des an TXD abgegebenen Signals bewirkten Ansteuerung entweder des ersten oder zweiten Schaltelements 22, 24 wäre der Pegel der Datenleitung 10 konstant entweder auf das erste oder zweite Bezugspotential bezogen. Ein Einprägen eines Sendesignals von einer Gegenstelle, etwa dem in FIG 1 dargestellten Master 12, wäre nicht möglich. Dementsprechend ist zur Sende-Empfangs-Umschaltung ein Sende-Empfangs-Umschalter 40 vorgesehen, der die Datenleitung 10 mittelbar entweder mit dem Ausgang TXD oder mit dem Eingang RXD verbindet. Die Sende-Empfangs-Umschaltung wird jeweils lokal vorgenommen, z. B. aufgrund eines Sendewunsches (Masterseite) oder nach Abarbeitung einer Sendeanforderung (Slaveseite). Dazu ist eine Umschaltleitung 42 vorgesehen, die über einen beim Ansatz gemäß der Erfindung nicht benötigten zusätzlichen Prozessorausgang aktiviert wird. In diesem Zusammenhang ist der Impulsgenerator 18 als Bestandteil eines Prozessors 44 gezeigt, der für die Generierung des Umschaltsignals erforderlich ist.

Die wesentlichen Vorteile der Erfindung bestehen entsprechend darin, dass der Entladeimpuls 34 aus dem vorhandenen Sendesignal, also dem an TXD abgegebenen Signal generiert wird und dafür kein weiterer Prozessorausgang erforderlich ist. Darüber hinaus kann eine ansonsten erforderliche Sende-Empfangs-Umschaltung entfallen. Schließlich hat der Entladeimpuls 34 eine definierte vorgebbare Länge, so dass durch die Auswahl der Länge des Entladeimpulses 34 sichergestellt werden kann, dass eine ausreichende Entladung der Datenleitung 10 erfolgt, ohne dass der Entladeimpuls 34 so lang ist, dass nachfolgende Signale beeinflusst werden. Schließlich ist die Lösung temperaturstabiler als eine einfache dynamische Schaltung und bringt eine Kostenersparnis gegenüber bisher im Stand der Technik favorisierten Lösungen mit sich.

Damit lässt sich die Erfindung kurz wie folgt darstellen: Es wird eine Schaltung, insbesondere zur Verwendung bei "IO-Link", zur Generierung einer Rechteckimpulsfolge 16 als Sendesignal angegeben, wobei die Schaltung einen Impulsgenerator 18 und einen Entladeimpulsgenerator 20 umfasst und sich dadurch auszeichnet, dass der Entladeimpulsgenerator 20 einen Entladeimpuls 34 direkt aus dem Sendesignal generiert.

## Patentansprüche

1. Schaltung zur Generierung einer Rechteckimpulsfolge (16) als Sendesignal mit einem Impulsgenerator (18) und einem Entladeimpulsgenerator (20), **dadurch gekennzeichnet, dass** der Entladeimpulsgenerator (20) einen Entladeimpuls (34) aus dem Sendesignal generiert.

2. Schaltung nach Anspruch 1, wobei der Entladeimpulsgenerator (20) ein erstes und ein zweites ansteuerbares Schaltelement (22, 24) umfasst, wobei das erste Schaltelement (22) im angesteuerten Zustand eine Datenleitung (10), über die im Betrieb das Sendesignal übertragen wird, mit einem ersten Bezugspotential verbindet und das zweite Schaltelement (24) im angesteuerten Zustand die Datenleitung (10) mit einem zweiten Bezugspotential verbindet.

3. Schaltung nach Anspruch 2, wobei zur Verbindung der Datenleitung (10) entweder mit erstem oder zweitem Bezugspotential die Datenleitung (10) mit einem Mittelanschluss (26) einer Reihenschaltung von erstem und zweitem Schaltelement (22, 24) verbunden ist.

4. Schaltung nach Anspruch 2 oder 3, wobei zur Generierung des Entladeimpulses (34) das Sendesignal direkt auf das erste Schaltelement (22) und verzögert auf das zweite Schaltelement (24) wirkt.

5. Schaltung nach Anspruch 4, wobei zur verzögerten Wirkung auf das zweite Schaltelement (24) ein Verzögerungsglied (28) vorgesehen ist.

6. Schaltung nach Anspruch 4 oder 5, wobei zur Begrenzung einer Dauer des Entladeimpulses (34) (im Signalpfad zum zweiten Schaltelement ein Impulsglied (30) vorgesehen ist.

7. Schaltung nach einem der vorangehenden Ansprüche zur Verwendung bei IO-Link.

8. Verwendung der Schaltung nach einem der Ansprüche 2 bis 6, zur Erzeugung eines Entladeimpuls (34) direkt aus einer Rechteckimpulsfolge (16) als Sendesignal, wobei für die Rechteckimpulsfolge (16) und die Datenleitung (10) vorgegebene technische Randbedingungen beachtet werden, nämlich Low-Pegel:0V-8V; High-Pegel: 13V-30V; Flankensteilheit: 20% der Bitzeit, insbesondere t=800ns; maximaler Stromwert: I≤200mA sowie eine maximale kapazitive Last von 5nF für die Datenleitung (10).
